# DEMANDE DE BREVET EUROPEEN

(11) **EP 3 477 716 A1**
(43) Date de publication de la demande: **01.05.2019**
(21) Numéro de dépôt: 18202884.5
(22) Date de dépôt: 26.10.2018
(51) Int. Cl.: H01L 45/00, G11C 13/00

(54) **POINT MÉMOIRE À MATÉRIAU À CHANGEMENT DE PHASE**

(30) Priorité: 27.10.2017 FR 1760164
(71) Demandeur: STMicroelectronics (Crolles 2) SAS, 38920 Crolles (FR)
(72) Inventeur: MORIN, Pierre, 38000 GRENOBLE (FR); ARNAUD, Franck, 38330 SAINT NAZAIRE LES EYMES (FR); DUTARTRE, Didier, 38240 MEYLAN (FR)
(74) Mandataire: Cabinet Beaumont

(57) **Abrégé**

L'invention concerne une point mémoire à matériau à changement de phase comprenant, sur un via (108) de liaison avec un transistor, un élément de chauffage (116) du matériau à changement de phase (118), et, entre le via et l'élément de chauffage, une barrière thermique (202) électriquement conductrice.

## Description

### Domaine

La présente demande concerne les puces électroniques, et plus particulièrement un point mémoire non volatile à matériau à changement de phase.

### Exposé de l'art antérieur

Dans un point mémoire à matériau à changement de phase, le matériau à changement de phase est par exemple un chalcogénure cristallin. Pour programmer un tel point mémoire, on chauffe le chalcogénure pour en faire fondre une partie. Après arrêt du chauffage, la partie fondue se refroidit suffisamment vite pour devenir amorphe. L'effacement du point mémoire est obtenu en chauffant le chalcogénure sans le faire fondre, afin que la partie amorphe recristallise. La lecture de l'état du point mémoire, programmé ou effacé, utilise la différence entre la conductivité électrique du chalcogénure amorphe et celle du chalcogénure cristallin.

Les points mémoire à changement de phase connus présentent divers inconvénients tels qu'un courant élevé pour la programmation, et divers problèmes de compacité. Ces problèmes sont cruciaux par exemple pour une puce électronique comprenant plusieurs millions, voire plusieurs milliards, de tels points mémoire.

### Résumé

Un mode de réalisation prévoit de pallier tout ou partie des inconvénients ci-dessus.

Ainsi, un mode de réalisation prévoit un point mémoire à matériau à changement de phase comprenant, sur un via de liaison avec un transistor, un élément de chauffage du matériau à changement de phase, et, entre le via et l'élément de chauffage, une barrière thermique électriquement conductrice.

Selon un mode de réalisation, la barrière thermique comprend un matériau thermiquement plus isolant que celui du via.

Selon un mode de réalisation, la barrière thermique comprend un matériau de résistivité thermique supérieure à 0,02 m·K/W.

Selon un mode de réalisation, la barrière thermique comprend un matériau choisi dans le groupe comprenant : les nitrures de titane ; les nitrures de silicium et de titane ; les siliciures ; le silicium amorphe dopé ; le silicium-germanium dopé ; et le germanium amorphe dopé.

Selon un mode de réalisation, l'épaisseur de la barrière thermique est supérieure à 10 nm.

Selon un mode de réalisation, la barrière thermique comprend une couche d'un matériau formant avec ceux du via et de l'élément de chauffage des résistances thermiques d'interface.

Selon un mode de réalisation, lesdites résistances thermiques d'interface sont supérieures à 2·10⁻⁹ m²·K/W.

Selon un mode de réalisation, la barrière thermique comprend un matériau choisi dans le groupe comprenant : les nitrures de titane ; le silicium dopé ; le silicium-germanium dopé ; le germanium dopé ; et le graphène.

Selon un mode de réalisation, la barrière thermique comprend, dans un matériau électriquement isolant, un chemin électriquement conducteur obtenu par claquage.

Selon un mode de réalisation, la barrière thermique comprend deux couches formant entre elles une résistance thermique d'interface.

Un mode de réalisation prévoit un procédé de fabrication d'un point mémoire à matériau à changement de phase, comprenant : a) former un via de liaison avec un transistor ; b) former sur le via un élément de chauffage du matériau à changement de phase ; et c) entre les étapes a) et b), former une couche en un matériau électriquement conducteur adapté à former à l'étape b) une barrière thermique entre le via et l'élément de chauffage, et/ou adapté à former avec le via et l'élément de chauffage des interfaces formant une barrière thermique.

Selon un mode de réalisation, le procédé comprend en outre : d) entre les étapes a) et c), graver une partie supérieure du via; et e) après l'étape c), retirer les portions de ladite couche situées en dehors de la partie gravée à l'étape d) .

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue schématique en coupe d'un point mémoire à matériau à changement de phase ;
la figure 2 est une vue en coupe, partielle et schématique, d'un mode de réalisation d'un point mémoire à matériau à changement de phase ;
les figures 3A à 3D sont des vues en coupe, partielles et schématiques, illustrant des étapes d'un mode de réalisation d'un procédé de fabrication d'un point mémoire à matériau à changement de phase ; et
les figures 4A à 4D sont des vues en coupe, partielles et schématiques, illustrant des étapes d'un autre mode de réalisation d'un procédé de fabrication d'un point mémoire à matériau à changement de phase.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés.

Dans la description qui suit, lorsque l'on fait référence à des qualificatifs de position absolue, tels que les termes "haut", "bas", etc., ou relative, tels que les termes "dessus", "dessous", "supérieur", "inférieur", etc., ou à des qualificatifs d'orientation, tels que les termes "horizontal", "vertical", etc., il est fait référence à l'orientation de l'élément concerné dans les figures, étant entendu que, dans la pratique, les dispositifs décrits peuvent être orientés différemment.

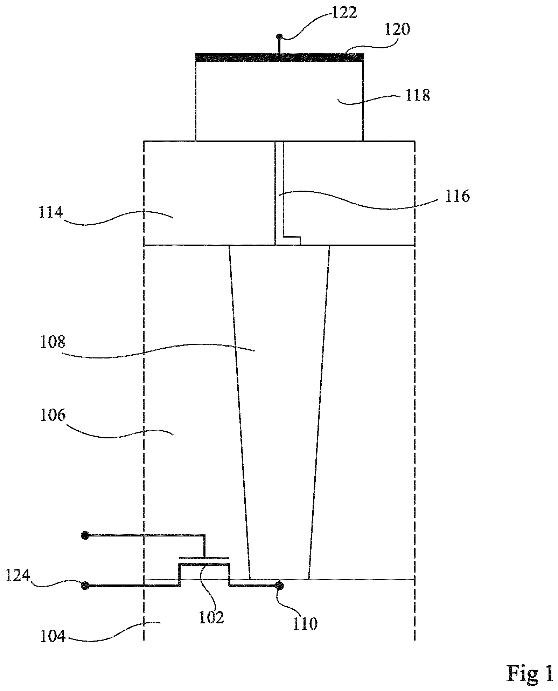

La figure 1 est une vue schématique en coupe d'un point mémoire à matériau à changement de phase.

Un transistor 102, par exemple de type MOS, mais pouvant aussi être de type bipolaire, est formé dans et sur un support semiconducteur 104. Ce transistor est représenté de façon symbolique. Le transistor 102 et le support 104 sont recouverts d'une couche 106 électriquement isolante, par exemple en oxyde de silicium. Un via électriquement conducteur 108, par exemple en tungstène, traverse la couche 106 de part en part et a son extrémité inférieure en contact avec le drain 110 du transistor 102. La couche 106 et le via 108 sont recouverts d'une couche électriquement isolante 114, par exemple en nitrure de silicium, traversée de part en part par un élément résistif 116. L'élément résistif 116 est disposé sur le via 108 et est en contact avec le via 108. L'élément résistif est par exemple en nitrure de silicium et de titane TiSiN, et est typiquement en forme de mur d'épaisseur par exemple comprise entre 2 et 10 nm, de largeur par exemple supérieure à 15 nm et de hauteur par exemple comprise entre 30 et 150 nm. L'élément résistif 116 et la couche isolante 114 sont surmontés d'un matériau à changement de phase 118 recouvert d'une prise de contact 120 reliée à un noeud 122. Le matériau à changement de phase 118, l'élément résistif 116 et le transistor 102 se trouvent ainsi reliés électriquement en série entre le noeud 122 et la source 124 du transistor 102.

Pour programmer ou effacer le point mémoire, on sélectionne le point mémoire en rendant le transistor 102 passant, et on applique une tension entre le noeud 122 et la source 124. Un courant passe dans l'élément résistif, ce qui produit de la chaleur, et la température de l'élément résistif s'élève fortement. Le matériau à changement de phase au contact de l'élément résistif de chauffage 116 fond (pour la programmation) ou recristallise (pour l'effacement).

Un problème est qu'une partie de la chaleur produite n'est pas utilisée pour élever la température de l'élément de chauffage 116 et ainsi faire fondre ou recristalliser le matériau 118, mais est absorbée ou évacuée par les matériaux environnant l'élément de chauffage, notamment par le via conducteur 108, selon les dimensions et les matériaux du via. Il faut alors produire beaucoup de chaleur pour obtenir, dans l'élément de chauffage, une température suffisante pour que le point mémoire soit programmé ou effacé. Il en résulte le problème, évoqué en préambule, de courants de programmation et d'effacement élevés. Le transistor 102 doit être de grande taille pour permettre le passage de ces courants, ce qui pose les problèmes de compacité susmentionnés.

On propose ci-après un point mémoire à courants de programmation et d'effacement réduits, ce point mémoire pouvant alors être particulièrement compact.

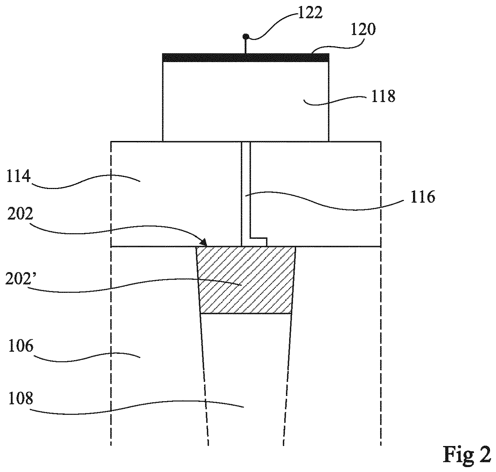

La figure 2 est une vue en coupe, partielle et schématique, d'un mode de réalisation d'un point mémoire. Seules les parties supérieures des points mémoire sont représentées en figures 2 et suivantes. Le point mémoire de la figure 2 reprend les éléments du point mémoire de la figure 1, ou des éléments similaires, agencés de manière identique ou similaire. Seules les différences entre les points mémoire des figures 1 et 2 sont mises en exergue ci-après.

Dans le point mémoire de la figure 2, une barrière thermique 202 est disposée entre le via 108 et l'élément résistif de chauffage 116. A titre d'exemple, le via 108 n'atteint pas la surface supérieure de la couche 106, et la barrière thermique est en prolongement du via à l'extrémité supérieure du via et atteint la surface de la couche 106. La barrière 202 comprend un matériau électriquement conducteur en contact avec le via 108 et avec l'élément de chauffage 116, ce qui permet le passage de courant, en particulier de programmation et d'effacement, entre le via 108 et l'élément 116.

La barrière thermique permet de réduire fortement les pertes vers le via 108 de la chaleur produite dans l'élément de chauffage 116. Il suffit donc d'une quantité réduite de chaleur produite pour que la température de l'élément de chauffage 116 s'élève fortement et que le point mémoire soit programmé ou effacé. Les courants de programmation et d'effacement sont donc particulièrement réduits.

A titre d'exemple, pour réduire les pertes de chaleur de l'élément 116 vers le via 108, la barrière thermique est en un matériau thermiquement plus isolant que celui du via. La barrière thermique est alors par exemple : en nitrure de titane, en nitrure de silicium et de titane, en un siliciure, ou en tellure de plomb ou de bismuth ; en un semiconducteur amorphe dopé tel que le silicium amorphe dopé ou le germanium amorphe dopé ; en un alliage, par exemple semiconducteur dopé tel que le silicium-germanium dopé ; ou en un matériau ayant une résistivité thermique supérieure à 0,02 m·K/W, par exemple supérieure à 0,1 m·K/W. La barrière thermique a par exemple une épaisseur supérieure à 5 nm.

A titre de variante, pour réduire les pertes de chaleur de l'élément 116 vers le via 108, la barrière thermique est constituée, au moins partiellement, par les interfaces formées par une couche 202' avec le via 108 et l'élément de chauffage. Pour cela, le matériau de la couche 202', différent de ceux du via et de l'élément de chauffage, est choisi pour que ces différences entre matériaux produisent, de chaque côté de la couche 202', une résistance thermique d'interface (en anglais "Interfacial thermal resistance"), c'est-à-dire une résistance qui s'oppose au passage de la chaleur entre deux matériaux différents en contact l'un avec l'autre. Cette résistance d'interface apparaît par exemple lorsque les vibrations, ou phonons, des réseaux cristallins des matériaux se propagent différemment dans les deux matériaux, et/ou ont des fréquences différentes dans les deux matériaux. Les phonons ont alors tendance à être réfléchis par l'interface. On choisit le matériau de la couche 202' pour que les interfaces entre ce matériau et les matériaux du via 108 et de l'élément de chauffage aient des résistances thermiques par exemple supérieures à 10⁻⁸ m²·K/W. La couche 202' peut alors avoir une épaisseur par exemple inférieure à 10 nm, par exemple comprise entre 1 et 5 nm. La couche 202' peut être une monocouche bidimensionnelle telle qu'une couche de graphène. A titre d'exemple, la couche 202' est en nitrure de titane, en silicium, en silicium-germanium ou en germanium, ces semiconducteurs étant suffisamment dopés pour être électriquement conducteurs.

En fonctionnement, le courant électrique, en particulier de programmation ou d'effacement, passe de l'élément de chauffage 116 au via 108 à travers la barrière thermique 202. Pour cela, on prévoit par exemple que la barrière présente entre le via 108 et l'élément 116 une résistance électrique négligeable, par exemple égale à moins de 10 % de celle de l'élément 116. Ceci peut être obtenu lorsque la conductivité électrique du matériau de la barrière thermique est par exemple supérieure à 2.10⁴ s/m.

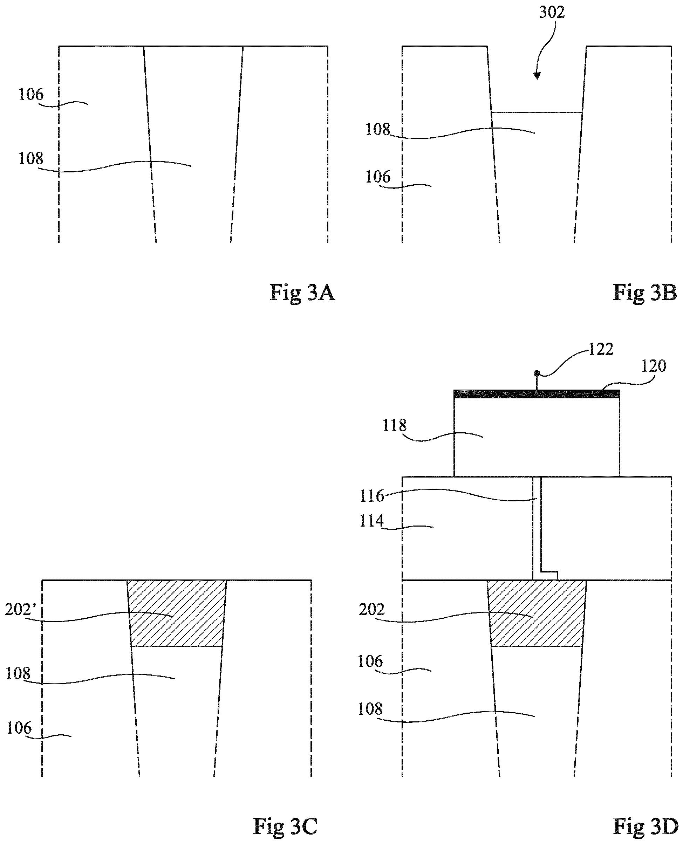

Les figures 3A à 3D sont des vues en coupe, partielles et schématiques, illustrant des étapes successives d'un mode de réalisation d'un procédé de fabrication d'un point mémoire à matériau à changement de phase, par exemple du type de celui de la figure 2.

A l'étape de la figure 3A, on a formé dans une couche isolante 106, par exemple en oxyde de silicium, un via 108, par exemple en tungstène, connecté au drain d'un transistor non représenté. Le via 108 affleure la surface supérieure de la couche isolante 106, par exemple suite à un polissage mécanochimique.

A l'étape de la figure 3B, on grave partiellement, de manière sélective, une partie supérieure du via 108. A titre d'exemple, après gravure, le niveau supérieur du via 108 est 5 à 50 nm en dessous de celui de la couche 106. Le via 108 est ainsi surmonté d'une cavité 302.

A l'étape de la figure 3C, on forme sur la structure une couche 202' remplissant la cavité 302 gravée à l'étape 3B. La couche 202' et/ou ses interfaces avec les matériaux qui l'environnent sont destinées à former la future barrière thermique 202. La couche 202' est électriquement conductrice, par exemple en un des matériaux décrits ci-dessus en relation avec la figure 2.

On retire ensuite tous les éléments situés au-dessus de la surface supérieure de la couche 106, par exemple par polissage mécanochimique.

A l'étape de la figure 3D, on forme le reste du point mémoire, à savoir une couche isolante 114 traversée par un élément de chauffage 116, la couche isolante 114 étant surmontée d'un matériau à changement de phase 118 en contact avec l'élément de chauffage 116.

On obtient une barrière thermique 202 entre le via 108 et l'élément de chauffage 116. La barrière thermique est située sur le via 108 et dans le prolongement du via 108, c'est-à-dire que sa forme en vue de dessus coïncide avec celle du via. La surface supérieure de la barrière 202 affleure celle de la couche 106.

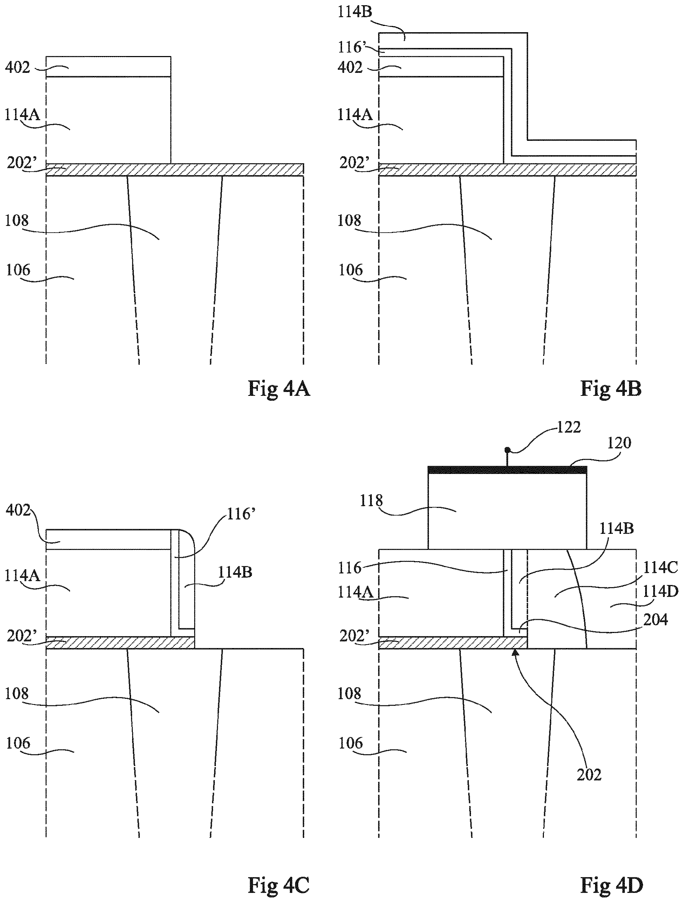

Les figures 4A à 4D sont des vues en coupe, partielles et schématiques, illustrant des étapes d'un autre mode de réalisation d'un procédé de fabrication d'un point mémoire à matériau à changement de phase.

A l'étape de la figure 4A, on a formé dans une couche isolante 106, par exemple en oxyde de silicium, un via 108, par exemple en tungstène, connecté au drain d'un transistor non représenté. Le via 108 affleure la surface supérieure de la couche isolante 106, par exemple suite à un polissage mécanochimique.

On forme sur la structure une couche 202'. La couche 202' et/ou ses interfaces avec les matériaux qui l'environnent sont destinés à former la future barrière thermique. La couche 202' est électriquement conductrice, par exemple en un des matériaux décrits ci-dessus en relation avec la figure 2. Dans le cas de matériaux formant des résistances thermiques d'interface avec les matériaux environnant la couche 202', l'épaisseur de la couche 202' peut avoir une épaisseur inférieure à 10 nm, voire à 1 nm. La couche 202' peut alors être en graphène. Le graphène formera des résistances thermiques d'interface particulièrement élevées avec le via 108 et l'élément de chauffage 116, par exemple pour un via en tungstène et un futur élément de chauffage en nitrure de silicium et de titane.

On recouvre ensuite la structure d'une couche électriquement isolante 114A, par exemple en nitrure de silicium, puis d'une couche 402, par exemple en oxyde de silicium. La couche 114A est une portion d'une future couche isolante 114 traversée par un futur élément résistif 116 de chauffage. A titre d'exemple, l'épaisseur de la couche 114 est comprise entre 30 et 150 nm.

Après cela, on grave les couches 402 et 114A de sorte qu'un flanc des portions restantes de ces couches soit situé sur le via 108.

A l'étape de la figure 4B, on forme successivement sur la structure une couche 116' et une couche 114B. Le futur élément résistif de chauffage sera formé d'une portion de la couche 116', la couche 116' étant par exemple en nitrure de silicium et de titane. La couche 114B est électriquement isolante, par exemple en nitrure de silicium, et est d'épaisseur par exemple comprise entre 10 et 50 nm.

A l'étape de la figure 4C, on élimine par gravure anisotrope les parties horizontales de la couche 114B. On grave ensuite les parties accessibles des couches 116' et 202'.

A l'étape de la figure 4D, on procède successivement au dépôt d'une couche 114C électriquement isolante, par exemple en nitrure de silicium, et à la gravure des parties horizontales de la couche 114C. Il en résulte une portion de la couche 114C recouvrant la partie restante, verticale, de la couche 114B.

On recouvre ensuite la structure d'une couche 114D électriquement isolante, par exemple en oxyde de silicium, de façon à remplir tout l'espace resté libre sous le niveau supérieur de la couche 114A.

Après cela, on retire tous les éléments de la structure situés au-dessus du niveau supérieur de la couche 114A, par exemple par polissage mécanochimique, puis on forme une région en matériau à changement de phase 118, recouverte d'une prise de contact 120.

On obtient ainsi, dans une couche électriquement isolante 114 composée des portions restantes des couches 114A, 114B, 114C et 114D, un élément résistif 116 de chauffage du matériau à changement de phase 118. L'élément résistif 116 obtenu par le procédé décrit ci-dessus comprend un mur vertical, et une portion horizontale 204 qui s'étend d'un côté à partir du bas du mur. La barrière thermique est située entre le via 108 et la portion 204 de l'élément de chauffage 116.

Des modes de réalisation particuliers ont été décrits. Diverses variantes et modifications apparaîtront à l'homme de l'art. En particulier, bien que les barrières thermiques décrites dans les modes de réalisation ci-dessus comprennent une couche électriquement conductrice 202' en un seul matériau, d'autres barrières thermiques électriquement conductrices, c'est-à-dire comprenant un ou plusieurs matériaux électriquement conducteurs, sont possibles.

A titre d'exemple, la couche 202' peut comprendre plusieurs couches superposées, chacune par exemple en un des matériaux décrits ci-dessus. On choisit alors, pour les matériaux de deux couches successives comprises dans la couche 202', des matériaux formant entre eux une résistance thermique d'interface élevée, par exemple supérieure à 2·10⁻⁹ m²·K/W, de préférence supérieure à 10⁻⁸ m²·K/W. L'efficacité de la barrière thermique est d'autant plus élevée que le nombre d'interfaces est élevée. Les couches superposées formant la couche 202' peuvent alors être déposées de manière conforme dans les divers procédés décrits ci-dessus.

A titre de variante, pour obtenir une barrière comprenant des portions de couches conductrices superposées dans le procédé des figures 3A à 3D, on peut successivement, après l'étape de la figure 3C :
- graver partiellement une partie supérieure de la portion de la couche 202' située dans la partie 302 gravée à l'étape 3B ;
- recouvrir la structure d'une couche supplémentaire en un matériau électriquement conducteur remplissant la partie gravée de la couche 202' ; et
- retirer les éléments situés au-dessus du niveau supérieur de la couche 106.

On obtient alors entre le via 108 et l'élément de chauffage 116 des portions superposées de la couche 202' et de la couche supplémentaire. De préférence, les matériaux de la couche 202' et de la couche supplémentaire forment entre eux une résistance thermique d'interface élevée.

A titre d'autre exemple, on peut obtenir la couche conductrice 202' en formant une couche d'un matériau électriquement isolant puis en créant un chemin de matériaux électriquement conducteurs entre le via 108 et l'élément de chauffage 116 à travers cette couche isolante, par exemple par claquage du matériau électriquement isolant en appliquant à une étape ultérieure une tension suffisamment élevée entre le via et l'élément de chauffage. Le matériau électriquement isolant est alors par exemple un oxyde, par exemple d'aluminium ou d'hafnium, ou du nitrure de silicium.

Divers modes de réalisation avec diverses variantes ont été décrits ci-dessus. On notera que l'homme de l'art pourra combiner divers éléments de ces divers modes de réalisation et variantes sans faire preuve d'activité inventive. En particulier, à l'étape de la figure 4A, on peut remplacer la structure sur laquelle on forme la couche 202' par la structure de la figure 3C.

## Revendications

1. Point mémoire à matériau à changement de phase comprenant, sur un via (108) de liaison avec un transistor (102), un élément de chauffage (116) du matériau à changement de phase (118), et, entre le via et l'élément de chauffage, une barrière thermique (202) électriquement conductrice.

2. Point mémoire selon la revendication 1, dans lequel la barrière thermique (202) comprend un matériau thermiquement plus isolant que celui du via (108).

3. Point mémoire selon la revendication 2, dans lequel la barrière thermique (202) comprend un matériau de résistivité thermique supérieure à 0,02 m·K/W.

4. Point mémoire selon la revendication 2 ou 3, dans lequel la barrière thermique (202) comprend un matériau choisi dans le groupe comprenant : les nitrures de titane ; les nitrures de silicium et de titane ; les siliciures ; le silicium amorphe dopé; le silicium-germanium dopé ; et le germanium amorphe dopé.

5. Point mémoire selon l'une quelconque des revendications 2 à 4, dans lequel l'épaisseur de la barrière thermique est supérieure à 10 nm.

6. Point mémoire selon l'une quelconque des revendications 1 à 5, dans lequel la barrière thermique (202) comprend une couche (202') d'un matériau formant avec ceux du via (108) et de l'élément de chauffage (116) des résistances thermiques d'interface.

7. Point mémoire selon la revendication 6, dans lequel lesdites résistances thermique d'interface sont supérieures à 2·10⁻⁹ m²·K/W.

8. Point mémoire selon la revendication 6 ou 7, dans lequel la barrière thermique (202) comprend un matériau choisi dans le groupe comprenant : les nitrures de titane ; le silicium dopé; le silicium-germanium dopé; le germanium dopé; et le graphène.

9. Point mémoire selon la revendication 6 ou 7, dans lequel la barrière thermique (202) comprend, dans un matériau électriquement isolant, un chemin électriquement conducteur obtenu par claquage.

10. Point mémoire selon l'une quelconque des revendications 1 à 9, dans lequel la barrière thermique comprend deux couches formant entre elles une résistance thermique d'interface.

11. Procédé de fabrication d'un point mémoire à matériau à changement de phase, comprenant :
a) former un via (108) de liaison avec un transistor ;
b) former sur le via un élément de chauffage (116) du matériau à changement de phase (118) ; et
c) entre les étapes a) et b), former une couche (202') en un matériau électriquement conducteur adapté à former à l'étape b) une barrière thermique (202) entre le via et l'élément de chauffage, et/ou adapté à former avec le via et l'élément de chauffage des interfaces formant une barrière thermique.

12. Procédé selon la revendication 11, comprenant en outre :
d) entre les étapes a) et c), graver une partie supérieure du via (108) ; et
e) après l'étape c), retirer les portions de ladite couche (202') situées en dehors de la partie gravée à l'étape d) .
